# EUROPÄISCHE PATENTSCHRIFT

(11) **EP 3 111 269 B1**
(45) Veröffentlichungstag und Bekanntmachung des Hinweises auf die Patenterteilung: **11.08.2021**
(21) Anmeldenummer: 15708760.2
(22) Anmeldetag: 23.02.2015
(51) Int. Cl.: G02B 26/08, G03F 7/20

(54) **BÜNDELVERTEILUNGSOPTIK, BELEUCHTUNGSOPTIK MIT EINER DERARTIGEN BÜNDELVERTEILUNGSOPTIK, OPTISCHES SYSTEM MIT EINER DERARTIGEN BELEUCHTUNGSOPTIK SOWIE PROJEKTIONSBELICHTUNGSANLAGE MIT EINEM DERARTIGEN OPTISCHEN SYSTEM**
BEAM DISTRIBUTING OPTICAL DEVICE, ILLUMINATING OPTICAL UNIT COMPRISING A BEAM DISTRIBUTING OPTICAL DEVICE OF SAID TYPE, OPTICAL SYSTEM COMPRISING AN ILLUMINATING OPTICAL UNIT OF SAID TYPE, AND PROJECTION LIGHTING APPARATUS COMPRISING AN OPTICAL SYSTEM OF SAID TYPE
OPTIQUE DE RÉPARTITION DE FAISCEAUX, OPTIQUE D'ÉCLAIRAGE POURVUE D'UNE OPTIQUE DE RÉPARTITION DE FAISCEAUX DE CE TYPE, SYSTÈME OPTIQUE COMPRENANT UNE OPTIQUE D'ÉCLAIRAGE DE CE TYPE ET INSTALLATION D'ÉCLAIRAGE PAR PROJECTION COMPRENANT UN SYSTÈME OPTIQUE DE CE TYPE

(30) Priorität: 25.02.2014 DE 102014203348
(43) Veröffentlichungstag der Anmeldung: 04.01.2017
(73) Patentinhaber: Carl Zeiss SMT GmbH, 73447 Oberkochen (DE)
(72) Erfinder: DEGÜNTHER, Markus, 73432 Aalen (DE); PATRA, Michael, 73447 Oberkochen (DE); KORB, Thomas, 73522 Schwäbisch Gmünd (DE)
(74) Vertreter: Rau, Schneck & Hübner Patentanwälte Rechtsanwälte PartGmbB
(86) Internationale Anmeldenummer: PCT/EP2015/053727
(87) Internationale Veröffentlichungsnummer: WO 2015/128288

(56) Entgegenhaltungen:
- DE-A1-102010 002 822
- DE-A1-102012 204 674
- US-A1- 2004 174 583

## Beschreibung

Die Erfindung betrifft eine Bündelverteilungsoptik zum Aufteilen eines einfallenden Bündels von Beleuchtungslicht in mindestens zwei ausfallende Nutz-Beleuchtungslicht-Bündel. Ferner betrifft die Erfindung eine Beleuchtungsoptik zur Ausleuchtung eines Objektfeldes mit einer derartigen Bündelverteilungsoptik, ein optisches System mit einer derartigen Beleuchtungsoptik und mindestens einer Projektionsoptik zur Abbildung des Objektfeldes in ein Bildfeld, eine Projektionsbelichtungsanlage mit einem derartigen System und einer primären Lichtquelle und ein Herstellungsverfahren für ein mikro- oder nanostrukturiertes Bauelement.

Beleuchtungsoptiken der eingangs genannten Art sind bekannt aus der DE 10 2012 204 647 A1, der WO 2011/157601 A2 und der US 2011/0228247 A1. Weitere Beleuchtungsoptiken sind bekannt aus der WO 2007/093433 A1 und der EP 1 262 836 A1. Die US 2004/0174583 A1 beschreibt einen MEMS-aktuierten Lichtmodulator. Die DE 10 2010 002 822 A1 offenbart ein Beleuchtungssystem für eine Mikrolithografie-Projektionsbelichtungsanlage mit einer Kollektoreinheit, einem reflektiven Gitter und einer in Lichtrichtung hierauf folgenden Nutzlichtwellenlängen-Selektionsvorrichtung mit mindestens einem Selektionsspiegel. Die DE 10 2006 047 913 A1 offenbart eine spektralanalytische Einheit mit einem Beugungsgitter, einer Kameraoptik, einer Detektorzeile und einer Auswerteelektronik. Die DE 10 2007 051 520 A1 offenbart einen räumlichen Lichtmodulator mit einem gitterbasierten Modulatorelement. Die US 2002/0079432 A1 offenbart ein zweidimensionales, geblazetes MEMS-Gitter.

Es ist eine Aufgabe der vorliegenden Erfindung, eine Optik derart weiterzubilden, dass eine effiziente Erzeugung mehrerer Beleuchtungslicht-Bündel aus einem einfallenden Bündel von Beleuchtungslicht erfolgt.

Diese Aufgabe ist erfindungsgemäß gelöst durch eine Bündelverteilungsoptik mit den im Anspruch 1 angegebenen Merkmalen.

Erfindungsgemäß wurde erkannt, dass die Nutzung eines Blaze-Reflexionsgitters die Möglichkeit einer einstellbaren Verteilung der Intensität eines einfallenden Beleuchtungslicht-Bündels auf die Intensitäten der ausfallenden Beleuchtungslicht-Bündel gewährleistet. Im Extremfall kann das Blaze-Reflexionsgitter so eingestellt werden, dass das gesamte einfallende Beleuchtungslicht-Bündel in genau ein ausfallendes Beleuchtungslicht-Bündel reflektiert wird. Das Blaze-Reflexionsgitter hat in diesem Fall ausschließlich die Funktion eines Umlenkspiegels. Das Blaze-Reflexionsgitter kann so eingestellt sein, dass eine vorgegebene Intensitätsverteilung in mehrere ausfallende Beleuchtungslicht-Bündel erfolgt, beispielsweise in zwei Beleuchtungslicht-Bündel oder auch in mehr als zwei Beleuchtungslicht-Bündel. Über eine entsprechende Gestaltung der Gitterstrukturen, insbesondere über den Abstand benachbarter Gitterstrukturen, also die Gitterperiode des Blaze-Reflexionsgitters, und über die Vorgabe eines Blaze-Winkels, lässt sich die Intensitätsverteilung in die verschiedenen ausfallenden Beleuchtungslicht-Bündel beeinflussen. Als Beleuchtungslicht kann insbesondere EUV-Licht in einem Wellenlängenbereich zwischen 5 nm und 30 nm zum Einsatz kommen. Als Beleuchtungslicht kann die Emission einer synchrotonstrahlungsbasierten Lichtquelle zum Einsatz kommen. Mit den über die Bündelverteilungsoptik erzeugten ausfallenden Beleuchtungslicht-Bündeln kann eine entsprechende Anzahl von Objektfeldern beleuchtet werden. Alternativ können die erzeugten, ausfallenden Beleuchtungslicht-Bündel auch gemeinsam ein und dasselbe Beleuchtungsfeld, beispielsweise mit unterschiedlichen Beleuchtungsparametern, beleuchten. Derart unterschiedliche Beleuchtungsparameter können sein: unterschiedliche Beleuchtungsrichtungen, unterschiedliche Polarisationen und/oder unterschiedliche Intensitäten. Beleuchtungslicht ist Licht, welches zur Beleuchtung eines Objekts tatsächlich zum Einsatz kommt.

Eine Gitterkonstante des Blaze-Reflexionsgitters und ein Blaze-Winkel des Blaze-Reflexionsgitters sind so auf eine Wellenlänge des Beleuchtungslichts abgestimmt, dass innerhalb eines über eine Auswahl des Blaze-Winkels bevorzugten Reflexionsbereichs des Blaze-Reflexionsgitters mehrere Beugungsordnungen des Blaze-Reflexionsgitters mit vorgegebener Effizienz reflektiert werden. Bei diesen mehreren Beugungsordnungen kann es sich um genau zwei Beugungsordnungen handeln. Bei diesen mehreren Beugungsordnungen kann es sich alternativ auch um mehr als zwei Beugungsordnungen, beispielsweise um drei Beugungsordnungen, um vier Beugungsordnungen, um fünf Beugungsordnungen oder um noch mehr Beugungsordnungen handeln. Das Blaze-Reflexionsgitter kann als Strahlteiler benutzt werden, wobei sowohl die Richtung der ausfallenden Nutz-Beleuchtungslicht-Bündel als auch die Verteilung der Intensitäten auf die ausfallenden Nutz-Beleuchtungslicht-Bündel über die Gitterkonstante und den Blaze-Winkel des Blaze-Reflexionsgitters vorgegeben werden können. Eine aktorische Verlagerbarkeit der Gitterstrukturen nach Anspruch 2 ermöglicht einen definierten Wechsel einer Intensitätsverteilung des einfallenden Beleuchtungslicht-Bündels in ausfallende Beleuchtungslicht-Bündel. Dieser Wechsel kann einen Wechsel der Anzahl der ausfallenden Beleuchtungslicht-Bündel beinhalten und/oder einen Wechsel hinsichtlich der Intensitätsanteile der ausfallenden Beleuchtungslicht-Bündel. Der Blaze-Winkel kann kontinuierlich oder auch stufenweise veränderlich sein.

MEMS-Spiegel als Gitterstruktur nach Anspruch 3 eignen sich zur Führung von Beleuchtungslicht.

Eine Gitterperiode nach Anspruch 4 hat sich zur Erzeugung ausreichender räumlicher Trennungen bei den ausfallenden Beleuchtungslicht-Bündeln als geeignet herausgestellt. Die Gitterperiode kann insbesondere 100 Mal so groß sein wie die Nutzwellenlänge des Beleuchtungslichts.

Sequenziell nach Anspruch 5 beaufschlagte Blaze-Reflexionsgitter haben sich zur Erzeugung einer größeren Anzahl von ausfallenden Beleuchtungslicht-Bündeln als besonders geeignet herausgestellt.

Eine kaskadierte Anordnung nach Anspruch 6, bei der jedes Beleuchtungslicht-Bündel in einem Lichtweg innerhalb der Bündelverteilungsoptik von den Gitterstrukturen mehrerer Blaze-Reflexionsgitter reflektiert wird, oder eine aufgefächerte Anordnung nach Anspruch 7 haben sich je nach den Anforderungen, die an die erzeugten Beleuchtungslicht-Bündel und/oder die an die Blaze-Reflexionsgitter gestellt werden, als besonders geeignet herausgestellt. Die Blaze-Reflexionsgitter können derart angeordnet sein, dass nach einer letzten Reflexion an einem der Blaze-Reflexionsgitter ausfallende Beleuchtungslicht-Bündel parallel zueinander propagieren. Dies hat sich für die Weiterverarbeitung der ausfallenden Beleuchtungslicht-Bündel als besonders geeignet herausgestellt.

Die Vorteile einer Beleuchtungsoptik nach Anspruch 8 und eines optischen Systems nach Anspruch 9 entsprechen denen, die vorstehend unter Bezugnahme auf die Bündelverteilungsoptik bereits erläutert wurden. Die Bündelverteilung kann zur Erzeugung mehrerer Bündel dienen, die sich in ein und demselben Beleuchtungsfeld überlagern oder zur Erzeugung mehrerer Bündel, die jeweils ein eigenes Beleuchtungsfeld ausleuchten.

Die zusätzliche Funktion einer Auskoppeloptik nach Anspruch 10 verringert die Anzahl der im optischen System zur Beleuchtungslicht-Umlenkung erforderlichen Komponenten. Dies ist insbesondere dann von Vorteil, wenn eine Reflexion des Beleuchtungslichts zu unerwünschten Verlusten führt.

Strahlführungen nach den Ansprüche 11 und 12 haben sich je nach den baulichen Anforderungen, die an das optische System gestellt sind, als besonders geeignet herausgestellt. Ein längs eines Zick-Zack-Weges verlaufendes, unausgekoppeltes Haupt-Bündel kann so geführt sein, dass bei aufeinanderfolgenden Umlenkungen längs des Zick-Zack-Weges das unausgekoppelte Haupt-Bündel ausschließlich von Blaze-Reflexionsgitter reflektiert ist. Eine entsprechend effiziente Auskopplung und Bündelverteilung ist die Folge.

Die Vorteile einer Projektionsbelichtungsanlage nach Anspruch 13 und eines Herstellungsverfahrens nach Anspruch 14 entsprechen denen, die vorstehend unter Bezugnahme auf die Bündelverteilungsoptik und das optische System bereits erläutert wurden. Diese Vorteile kommen bei Nutzung der Bündelverteilungsoptik mit EUV-Beleuchtungslicht, das von einer synchrotonstrahlungsbasierten primären Lichtquelle emittiert wird, besonders gut zum Tragen. Eine Projektionsbelichtungsanlage, bei der insbesondere gleichzeitig die Strukturen mehrerer Retikel auf zugeordnete Wafer projiziert werden können, mit entsprechend hohem Durchsatz ist die Folge.

Ausführungsbeispiele der Erfindung werden nachfolgend anhand der Zeichnung näher erläutert. In dieser zeigen:
- Fig. 1: stark schematisch eine Projektionsbelichtungsanlage für die Mikrolithografie mit einem optischen System mit einer Beleuchtungsoptik zur Ausleuchtung eines bei der Projektionsbelichtung abzubildenden Objektfeldes, wobei die Beleuchtungsoptik eine Bündelverteilungsoptik zum Aufteilen eines einfallenden Beleuchtungslicht-Bündels in insgesamt acht ausfallende Beleuchtungslicht-Bündel aufweist;
- Fig. 2: stärker im Detail eine Ausführung einer Bündelverteilungsoptik, die bei der Beleuchtungsoptik nach Fig. 1 zum Aufteilen des einfallenden Beleuchtungslicht-Bündels in zwei ausfallende Beleuchtungslicht-Bündel zum Einsatz kommen kann, wobei die Bündelverteilungsoptik ein Blaze-Reflexionsgitter mit zur Einstellung eines Blaze-Winkels aktorisch verlagerbaren Gitterstrukturen aufweist;
- Fig. 3: eine weitere Ausführung der Bündelverteilungsoptik zum Aufteilen des einfallenden Bündels in insgesamt acht ausfallende Beleuchtungslicht-Bündel;
- Fig. 4: eine Auskoppeloptik zur Auskopplung einzelner aus der Bündelverteilungsoptik nach Fig. 1 oder 3 ausfallender Beleuchtungslicht-Bündel hin zu jeweils einem bei der Projektionsbelichtung abzubildenden Objektfeld; und
- Fig. 5 bis 7: weitere Ausführungen von Bündelverteilungsoptiken mit nachgeordneten Auskoppeloptiken, die bei einer Projektionsbelichtungsanlage mit mehreren parallel mit Beleuchtungslicht beaufschlagbaren und bei der Projektionsbelichtung abzubildenden Objektfeldern zum Einsatz kommen können.

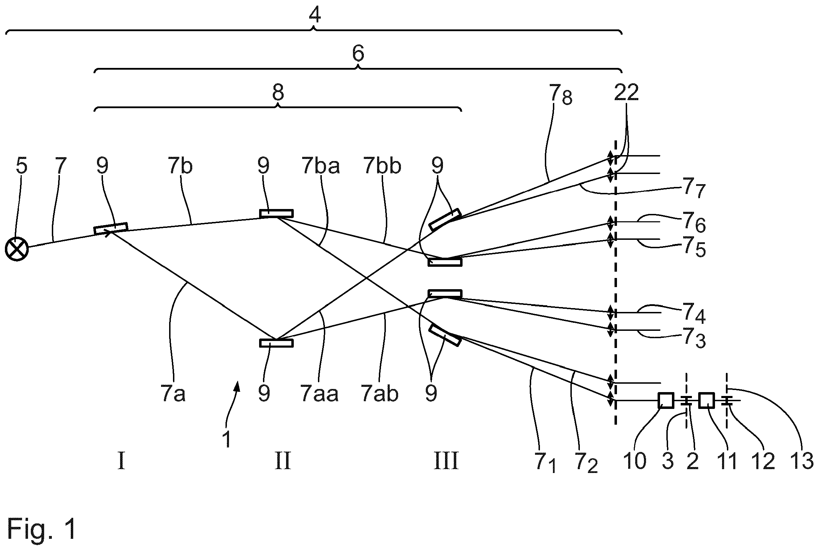

Figur 1 zeigt schematisch eine Mikrolithographie-Projektionsbelichtungsanlage 1, die mit insgesamt acht Wafer-Scannern ausgeführt ist und bei der Herstellung von Halbleiterbauelementen und anderen fein strukturierten Bauteilen eingesetzt wird. Eine als Scanner ausgeführte Projektionsbelichtungsanlage ist grundsätzlich bekannt aus der WO 2013/185919 A1. Die Projektionsbelichtungsanlage 1 arbeitet zur Erzielung von Auflösungen bis in den Bereich von Nanometern mit Licht insbesondere aus dem extremen Ultraviolettbereich (EUV), zum Beispiel im Bereich zwischen 5 nm und 30 nm.

Zur definierten Ausleuchtung von insgesamt acht Objekt- bzw. Beleuchtungsfeldern 2, jeweils in einer Objekt- oder Retikelebene 3, in der eine zu übertragende Struktur in Form eines nicht näher dargestellten Retikels angeordnet ist, dient ein insgesamt mit 4 bezeichnetes Beleuchtungssystem der Projektionsbelichtungsanlage 1. Dargestellt ist in der schematischen Figur 1 lediglich eines der insgesamt acht Objektfelder 2 sowie die vor- und nachgelagerten Komponenten.

Das Beleuchtungssystem 4 umfasst eine primäre Lichtquelle 5 und eine Beleuchtungsoptik 6 mit den optischen Komponenten zur Führung von Nutz-Beleuchtungs- bzw. Abbildungslicht 7 hin zum Objektfeld 2. Neben einer nachfolgend noch näher erläuterten Bündelverteilungsoptik 8 mit einer Mehrzahl kaskadiert angeordneter Blaze-Reflexionsgitter 9 gehört zur Beleuchtungsoptik 6 auch eine optische Bündelformungseinheit 10, die ein jeweiliges, aus der Bündelverteilungsoptik 8 ausfallendes Beleuchtungslicht-Bündel 7ᵢ (i = 1, ..., 8) zur Beleuchtung des jeweiligen Objektfeldes 2 formt. Zur jeweiligen Bündelformungseinheit 10 können ein Feldfacettenspiegel, ein Pupillenfacettenspiegel sowie eine Polarisationsoptik gehören. Die primäre Lichtquelle 5 ist eine synchrotonstrahlungsbasierte Lichtquelle, zum Beispiel ein Freie-Elektronen-Laser (FEL). Die Beleuchtungsoptik 6 ist ausschließlich mit reflektierenden Komponenten ausgeführt.

Mit jeweils einer Projektionsoptik 11 wird das jeweilige Objektfeld 2 abgebildet in ein Bildfeld 12 in einer Bildebene 13. Hierdurch bildet die Projektionsbelichtungsanlage 1 einen Abschnitt des Retikels im jeweiligen Objektfeld 2 auf einen Wafer in dem zugehörigen Bildfeld 12 ab. Das Retikel einerseits und der Wafer andererseits werden hierbei intermittierend oder kontinuierlich in einer Scan-Richtung verschoben.

Gemeinsam mit der jeweiligen Beleuchtungsoptik 6 bildet die Projektionsoptik 11 ein optisches System der Projektionsbelichtungsanlage 1.

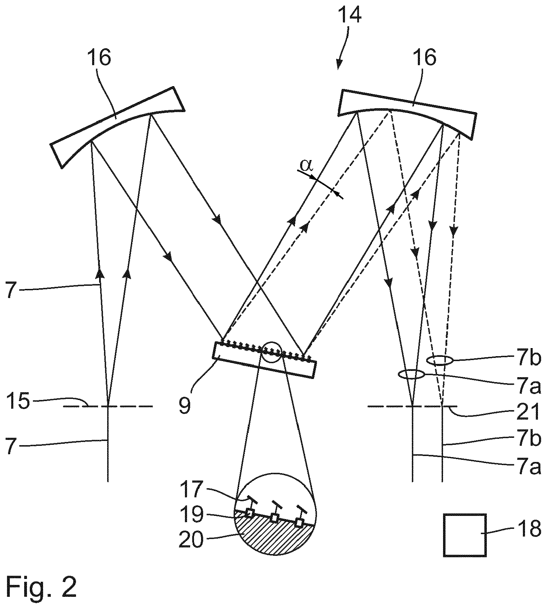

Figur 2 zeigt schematisch eine Ausführung einer Bündelverteilungsoptik 14 zum Aufteilen eines einfallenden Bündels des Beleuchtungslichts 7 in zwei ausfallende Beleuchtungslicht-Bündel 7a, 7b. Kern der Bündelverteilungsoptik 14 ist ein Blaze-Reflexionsgitter 9, das in entsprechender Form auch bei der Bündelverteilungsoptik 8 nach Figur 1 zum Einsatz kommen kann. Diesbezüglich gilt die nachfolgende Beschreibung der Bündelverteilungsoptik 14 auch für die Bündelverteilungsoptik 8 nach Figur 1.

Die Bündelverteilungsoptik 14 ist ähnlich einem Czerny-Turner-Monochromator aufgebaut, wird aber anders genutzt, wie nachfolgend beschrieben wird. Das einfallende Bündel des Beleuchtungslichts 7 durchtritt zunächst eine Zwischenfokusebene 15 und wird dann von einem Konkavspiegel 16 kollimiert. Das parallelisierte Bündel des Beleuchtungslichts 7 trifft dann auf das Blaze-Reflexionsgitter 9. Das Reflexionsgitter 9 ist nicht monolitisch ausgeführt. Die einzelnen Gitterperioden des Blaze-Reflexionsgitters 9 sind gebildet durch aktorisch verlagerbare MEMS-Spiegel 17, wie die Ausschnittsvergrößerung in der Figur 2 schematisch zeigt. Jeder MEMS-Spiegel 17 ist mit einem individuell über die zentrale Steuereinrichtung 18 ansteuerbaren Aktor 19 zur Einstellung eines Kippwinkels und damit eines Blaze-Winkels des Gitters 9 verbunden. Die MEMS-Spiegel 17 und die Aktoren 19 werden von einem Tragkörper 20 des Blaze-Reflexionsgitters 9 getragen. In Bezug auf die Größe der MEMS-Spiegel 17 und ihre Beabstandung ist die Figur 2 nicht maßstäblich.

Eine Gitterkonstante des Blaze-Reflexionsgitters 9 und ein Blaze-Winkel sind so auf die Wellenlänge des Beleuchtungslichts 7 abgestimmt, dass innerhalb des über die Auswahl des Blaze-Winkels bevorzugten Reflexionsbereichs des Gitters 9 mehrere Beugungsordnungen, insbesondere genau zwei Beugungsordnungen, des Gitters 9 mit vorgegebener Effizienz reflektiert werden. Dargestellt ist dies in der Figur 2 beispielhaft mit durchgezogenen Linien für eine erste Beugungsordnung des Blaze-Reflexionsgitters 9 für das Beleuchtungslicht 7 und mit gestrichelten Linien für eine zweite Beugungsordnung. Die erste Beugungsordnung ergibt das Beleuchtungslicht-Teilbündel 7a und die zweite Beugungsordnung ergibt das Beleuchtungslicht-Teilbündel 7b. Die Beleuchtungslicht-Teilbündel 7a, 7b durchlaufen nach Reflexion am Blaze-Reflexionsgitter 9 und an einem weiteren Konkavspiegel 16 zunächst eine weitere Zwischenfokusebene 21 und werden dann über zugeordnete Bündelformungseinheiten hin zu den jeweiligen Objektfeldern 2 zur Retikelbeleuchtung geführt, wie vorstehend im Zusammenhang der Ausführung nach Figur 1 bereits erläutert.

Eine Gitterperiode des Blaze-Reflexionsgitters 9 ist beispielsweise hundertmal so groß wie die Wellenlänge des Beleuchtungslichts 7. Bei einer Wellenlänge des Beleuchtungslichts 7 von 13 nm ergibt sich eine Gitterperiode von 1,3 µm.

Durch Verkippung der MEMS-Spiegel 17 und entsprechend der Vorgabe eines Blaze-Winkels lässt sich das Maximum der Reflexion über die möglichen Beugungswinkel der n-ten Ordnungen schieben, sodass sich ein Intensitätsverhältnis der sich ergebenden Beleuchtungslicht-Teilbündel 7a, 7b, ..., die vom Blaze-Reflexionsgitter 9 reflektiert werden, kontinuierlich einstellen lässt.

Bei der Bündelverteilungsoptik 8 nach Figur 1 werden Blaze-Reflexionsgitter 9 kaskadiert in einem Strahlengang angeordnet, der dem Strahlengang des Beleuchtungslichts 7 bei der Ausführung nach Figur 2 zwischen den beiden Konkavspiegeln 16 entspricht. Dabei wird ausgenutzt, dass schon das einfallende Bündel des Beleuchtungslichts 7 bei Verwendung der synchrotonstrahlungsbasierten Lichtquelle 5 parallelisiert ist. Zur Parallelisierung des Beleuchtungslichts 7 vor den Blaze-Reflexionsgittern 9 kann alternativ eine in der Figur 1 nicht dargestellte Strahlformungsoptik genutzt werden.

Bei der Bündelverteilungsoptik 8 nach Figur 1 sind insgesamt sieben Blaze-Reflexionsgitter 9 in drei Kaskaden I, II und III angeordnet.

Das Blaze-Reflexionsgitter 9 der Kaskade I erzeugt aus dem einfallenden Bündel des Beleuchtungslichts 7 zwei ausfallende Bündel 7a, 7b.

Die beiden Blaze-Reflexionsgitter 9 der folgenden Kaskade II erzeugen einerseits aus dem einfallenden Beleuchtungslicht-Bündel 7a zwei ausfallende Beleuchtungslicht-Bündel 7aa, 7ab und andererseits aus dem einfallenden Beleuchtungslicht-Bündel 7b zwei ausfallende Beleuchtungslicht-Bündel 7ba, 7bb.

Die vier Blaze-Reflexionsgitter 9 der nachfolgenden Kaskade III erzeugen aus dem einfallenden Beleuchtungslicht-Teilbündel 7aa zwei ausfallende Beleuchtungslicht-Teilbündel 7₇ und 7₈, aus dem einfallenden Beleuchtungslicht-Teilbündel 7bb zwei ausfallende Beleuchtungslicht-Teilbündel 7₆ und 7₅, aus dem einfallenden Beleuchtungslicht-Teilbündel 7ab zwei ausfallende Beleuchtungslicht-Teilbündel 7₄ und 7₃ sowie aus dem einfallenden Beleuchtungslicht-Teilbündel 7ba die ausfallenden Beleuchtungslicht-Teilbündel 7₂ und 7₁. Die ausfallenden Beleuchtungslicht-Teilbündel 7₁ bis 7₈ der letzten Kaskade III werden mit Hilfe von Spiegeln 22 parallel zueinander ausgerichtet. Im folgenden Strahlengang durchlaufen die acht ausfallenden Beleuchtungslicht-Teilbündel 7₁ bis 7₈ jeweils individuelle Strahlengänge mit zugehörigen Bündelformungseinheiten 10, die diese Beleuchtungslicht-Teilbündel 7₁ bis 7₈ zu insgesamt acht Objektfeldern 2 führen, die über zugeordnete Projektionsoptiken 11 auf jeweils ein zugeordnetes Bildfeld von insgesamt acht Bildfeldern 12 der Projektionsbelichtungsanlage 1 zur Projektion des im Objektfeld angeordneten Retikelabschnitts auf im Bildfeld angeordnete Wafer abgebildet werden.

Eine Polarisationsrichtung der ausfallenden Beleuchtungslicht-Teilbündel 7₁ bis 7₈ ist in der Figur 1 durch einen Doppelpfeil angedeutet.

Eine Intensitätsverteilung zwischen den acht Beleuchtungslicht-Teilbündeln 7₁ bis 7₈ kann durch entsprechende Verkippung der MEMS-Spiegel 17 und daraus folgende Verteilung der Reflexionseffizienz in die verschiedenen Beugungsordnungen der Beleuchtungslicht-Teilbündel 7₁ bis 7₈ vorgegeben werden.

Das jeweilige Blaze-Reflexionsgitter 9 kann unter streifendem Einfall des Beleuchtungslichts 7 betrieben werden.

Jedes der Blaze-Reflexionsgitter 9 kann so eingestellt werden, dass das einfallende Beleuchtungslicht 7 komplett in genau eine Beugungsordnung reflektiert wird. Auf diese Weise können die vorstehend beschriebenen Bündelverteilungsoptiken 8 und 14 so betrieben werden, dass eine geringere Anzahl an Objektfeldern ausgeleuchtet und damit eine geringere Anzahl von Projektionsbelichtungs-Scannern betrieben wird, als prinzipiell möglich. Die verbleibenden Scanner können dann beispielsweise mit höherer Intensität des Beleuchtungslichts 7 betrieben werden.

Ein Winkel α zwischen den Beugungsordnungen der ausfallenden Beleuchtungslicht-Teilbündel kann bei der Beleuchtungsverteilungsoptik 14 oder auch bei der Kaskade III der Bündelverteilungsoptik 8 kleiner sein als 2 mrad.

Eine Verteilung der Intensität des einfallenden Beleuchtungslicht-Bündels 7 in die ausfallenden Beleuchtungslicht-Bündel 7a, 7b innerhalb der Kaskaden I, II und III kann jeweils im Verhältnis 1:1 erfolgen. Dies gewährleistet eine Gleichverteilung der Intensitäten in Bezug auf die nachfolgend genutzten Beleuchtungslicht-Teilbündel 7₁ bis 7₈.

Bei der Bündelverteilungsoptik 8 nach Figur 1 erfährt jedes Beleuchtungslicht-Teilbündel 7₁ bis 7₈ genau drei Reflexionen an den Blaze-Reflexionsgittern 9.

Bei der Bündelverteilungsoptik 8 wird jedes Beleuchtungslicht-Bündel 7₁ bis 7₈ im Lichtweg innerhalb der Bündelverteilungsoptik 8 von den Gitterstrukturen 17 mehrerer Blaze-Reflexionsgitter, nämlich jeweils einem Blaze-Reflexionsgitter 9 der Kaskaden I, II und III, reflektiert.

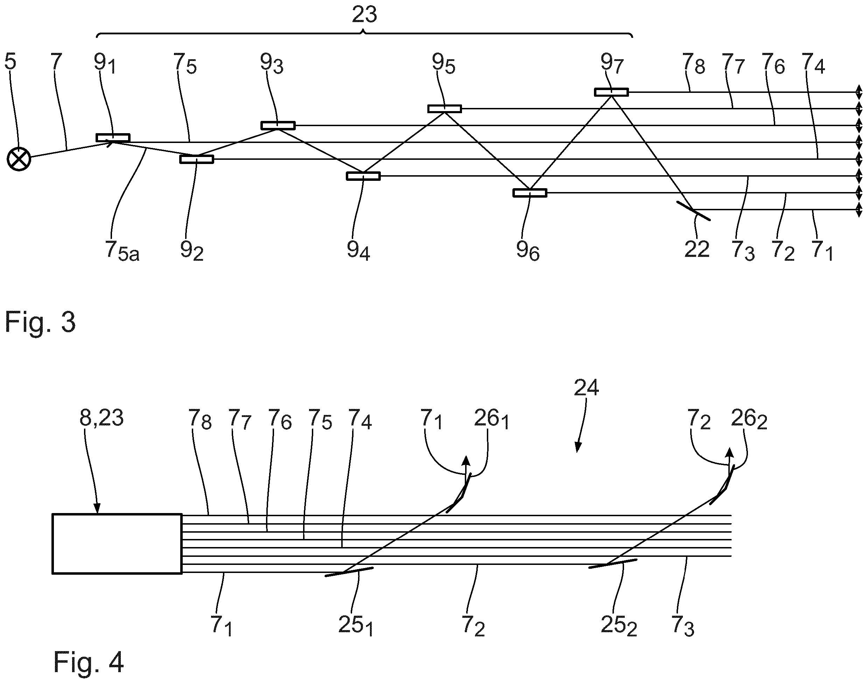

Figur 3 zeigt eine weitere Ausführung einer Bündelverteilungsoptik 23, die anstelle der Bündelverteilungsoptik 8 zum Einsatz kommen kann. Komponenten, die denjenigen entsprechen, die vorstehend unter Bezugnahme auf die Figuren 1 und 2 bereits erläutert wurden, tragen die gleichen Bezugsziffern und werden nicht nochmals im Einzelnen diskutiert.

Eine Anordnung der insgesamt sieben Blaze-Reflexionsgitter 9ᵢ (i= 1, ..., 7) ist bei der Bündelverteilungsoptik 23 so, dass von den zwei jeweils von einem Blaze-Reflexionsgitter 9 ausfallenden Beleuchtungslicht-Teilbündeln maximal eines an mindestens einem weiteren Blaze-Reflexionsgitter weiter aufgeteilt wird. Das Beleuchtungslicht-Teilbündel 7₅ ist bei der Bündelverteilungsoptik 23 ausschließlich durch Reflexion am im Strahlengang des Beleuchtungslichts 7 ersten Blaze-Reflexionsgitter 9₁ entstanden. Das Beleuchtungslicht-Teilbündel 7₄ ist im Strahlengang zuletzt am zweiten Blaze-Reflexionsgitter 9₂ reflektiert. Das Beleuchtungslicht-Teilbündel 7₆ ist zuletzt am dritten Blaze-Reflexionsgitter 9₃ reflektiert. Das Beleuchtungslicht-Teilbündel 7₃ ist zuletzt am vierten Blaze-Reflexionsgitter 9₄ reflektiert. Das Beleuchtungslicht-Teilbündel 7₇ ist zuletzt am fünften Blaze-Reflexionsgitter 9₅ reflektiert. Das Beleuchtungslicht-Teilbündel 7₂ ist zuletzt am sechsten Blaze-Reflexionsgitter 9₆ reflektiert. Das Beleuchtungslicht-Teilbündel 7₈ ist zuletzt am siebten und letzten Blaze-Reflexionsgitter 9₇ der Bündelverteilungsoptik reflektiert. Das Beleuchtungslicht-Teilbündel 7₁ ist nach Reflexion am letzten Blaze-Reflexionsgitter 9₇ noch an einem Umlenkspiegel 22 reflektiert.

Hinsichtlich der Zuordnung der Beleuchtungslicht-Teilbündel zur Anzahl der Reflexionen in der Bündelverteilungsoptik 23 gilt also folgende Tabelle:

| Beleuchtungslicht- Teilbündel | Zahl der Reflexionen in Bündelverteilungsoptik 23 |
|---|---|
| 7₁ | 8 |
| 7₂ | 6 |
| 7₃ | 4 |
| 7₄ | 2 |
| 7₅ | 1 |
| 7₆ | 3 |
| 7₇ | 5 |
| 7₈ | 7 |

Die unterschiedliche Anzahl der Reflexionen, die zur Erzeugung der Beleuchtungslicht-Teilbündel 7₁ bis 7₈ erforderlich ist, kann bei der Vorgabe jeweils geforderter Intensitäten der Beleuchtungslicht-Teilbündel 7₁ bis 7₈ genutzt werden.

Minimale Winkelabstände zwischen den Beugungsordnungen an den Gittern 9₁ bis 9₇ ergeben sich bei einem angenommenen Strahlquerschnitt in der Zeichenebene der Figur 3 von 10 mm und einem Abstand in einer in Figur 3 nach rechts verlaufenden Haupt-Propagationsrichtung des Beleuchtungslichts 7 zwischen den einzelnen Blaze-Reflexionsgittern 9ᵢ von jeweils 3 m gemäß folgender Tabelle:

| Blaze- Reflexionsgitter | Winkelabstand der Ausfallsrichtung zwischen den beiden genutzten Beugungsordnungen |
|---|---|
| 9₁ | 3,3 mrad |
| 9₂ | 6,7 mrad |
| 9₃ | 10 mrad |
| 9₄ | 13,3 mrad |
| 9₅ | 16,7 mrad |
| 9₆ | 20 mrad |
| 9₇ | 23,3 mrad |

Die Reflexionen an den Blaze-Reflexionsgittern 9₁ bis 9₇ können bei der Bündelverteilungsoptik 23 so vorgegeben werden, dass die Beleuchtungslicht-Teilbündel 7₂ bis 7₈ die Bündelverteilungsoptik 23 mit paralleler Propagationsrichtung verlassen.

Figur 4 zeigt beispielhaft eine Ausführung einer Auskoppeloptik 24 zur Auskopplung des jeweiligen Beleuchtungslicht-Teilbündels 7₁ bis 7₈ aus den gemeinsam parallel propagierenden Beleuchtungslicht-Teilbündeln hin zum jeweiligen Objektfeld. Diese Auskopplung erfolgt über jeweils mehrere Spiegel 25, 26, die unter streifendem Einfall, also als Grazing Incidence-Spiegel betrieben werden. Eine Gesamtumlenkung der jeweiligen Spiegelsequenz 25ᵢ, 26ᵢ zur Auskopplung des Beleuchtungslicht-Teilbündels 7ᵢ beträgt etwa 90°.

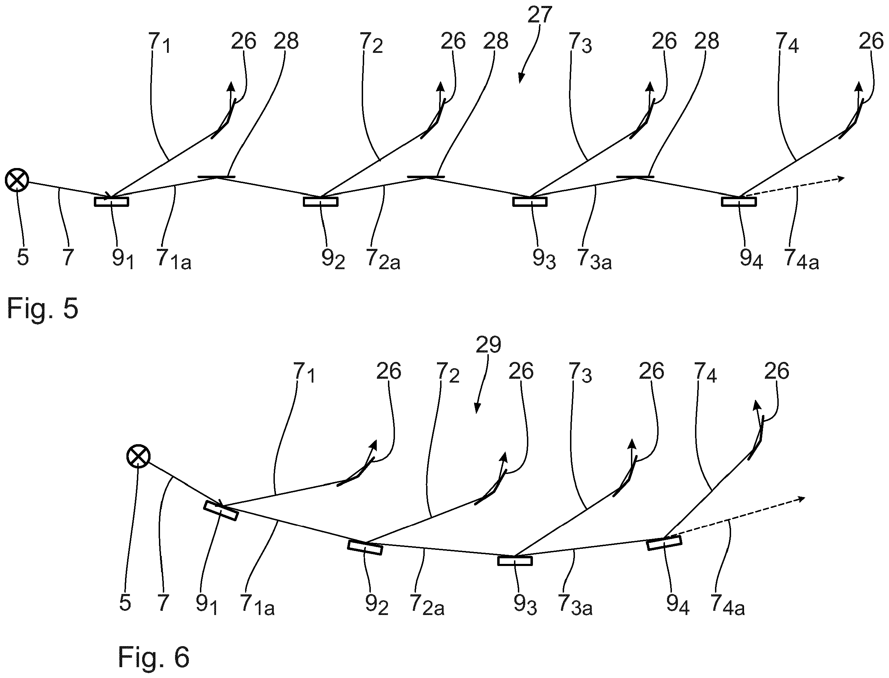

Figur 5 zeigt eine weitere Ausführung einer Bündelverteilungsoptik 27, die gleichzeitig die Funktion einer Auskoppeloptik nach Art der Auskoppeloptik 24 nach Figur 4 hat.

Eine Sequenz der Anordnung der Blaze-Reflexionsgitter 9₁, 9₂, ... ist bei der Bündelverteilungsoptik 27 vergleichbar zur Anordnung nach Figur 3. Von den jeweils zwei ausfallenden Beleuchtungslicht-Teilbündeln wird eines sofort hin zu einem Objektfeld ausgekoppelt (vgl. Beleuchtungslicht-Teilbündel 7₁ in Figur 5). Das andere ausfallende Beleuchtungslicht-Teilbündel (vgl. 7₁ₐ in Figur 5) wird hin zum nächsten Blaze-Reflexionsgitter 9₂ geführt. Um eine gemeinsame Einfallsebene der jeweiligen Beleuchtungslicht-Teilbündel 7 auf den Blaze-Reflexionsgittern 9ᵢ zu gewährleisten, erfolgt im Strahlengang zwischen den Blaze-Reflexionsgittern 9ᵢ, 9ᵢ₊₁ noch eine Umlenkung des jeweiligen Beleuchtungslicht-Teilbündels 7 über einen Umlenkspiegel 28.

Dargestellt ist die Bündelverteilungsoptik 27 zur Erzeugung von insgesamt vier Beleuchtungslicht-Teilbündeln 7₁ bis 7₄, die zur Beleuchtung von vier getrennten Objektfeldern 2 von entsprechenden Scannern zur Projektionsbelichtung von vier getrennten Retikeln verwendet werden können. Gestrichelt ist in der Figur 5 ein Strahlengang 7₄ₐ angedeutet, über den eine folgende Sequenz von Blaze-Reflexionsgittern 9₅, ... zur Erzeugung weiterer Beleuchtungslicht-Teilbündel 7₅, ... nachgeordnet sein kann.

Ein unausgekoppeltes Haupt-Beleuchtungslicht-Bündel 7, 7₁ₐ, 7₂ₐ, 7₃ₐ, 7₄ₐ verläuft bei der Bündelverteilungsoptik 27 längs eines Zick-Zack-Weges.

Das Gitter 9₁ kann die Teilbündel 7₅ einerseits und 7₅ₐ (hin zum Gitter 9₂) im Intensitätsverhältnis 1:7 auskoppeln. Über entsprechende asymmetrische Auskoppelverhältnisse kann gewährleistet werden, dass alle Beleuchtungslicht-Teilbündel 7₁ bis 7₈, die zur Objektfeldbeleuchtung verwendet werden, die gleichen Intensitäten haben.

Bei einer Bündelverteilungsoptik 29 nach Figur 6 sind im Vergleich zur Bündelverteilungsoptik 27 die Umlenkspiegel 28 weggelassen. Es ergibt sich eine Strahlführung des jeweils aufzuteilenden Beleuchtungslicht-Teilbündels derart, dass dieses unausgekoppelte Haupt-Beleuchtungslicht-Bündel 7, 7₁ₐ, 7₂ₐ, 7₃ₐ, ... längs eines polygonalen, jeweils in gleicher Richtung umgelenkten Weges verläuft.

Zur mikrolithografischen Herstellung mikro- bzw. nanostrukturierter Bauelemente mit der Projektionsbelichtungsanlage 1 wird zunächst jeweils ein Substrat bzw. ein Wafer im jeweiligen Bildfeld 12 in der Waferebene 13 bereitgestellt. Auf dem jeweiligen Wafer ist zumindest teilweise eine Schicht aus einem lichtempfindlichen Material aufgebracht. Weiterhin wird in der jeweiligen Retikelebene 3 jeweils ein Retikel bereitgestellt, das abzubildende Strukturen aufweist. Mit der Projektionsbelichtungsanlage 1 wird dann der im Objektfeld 2 angeordnete Teil des jeweiligen Retikels auf einen jeweils im Bildfeld angeordneten Bereich der jeweiligen Schicht projiziert.

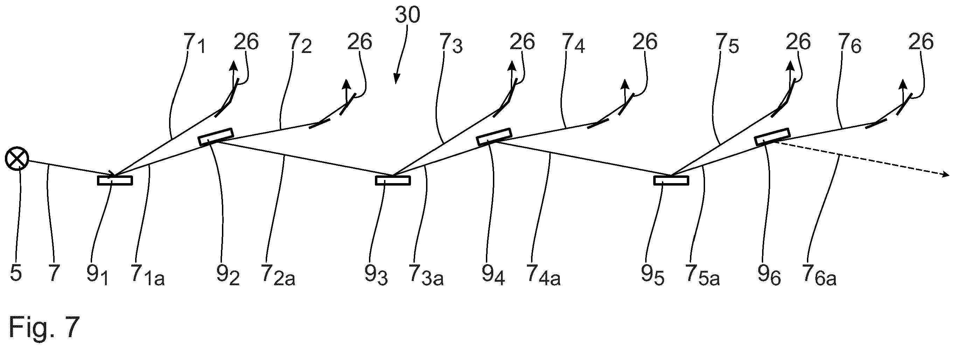

Figur 7 zeigt eine Bündelverteilungsoptik 30, die als Kombination der optischen Anordnungen nach den Figuren 5 und 6 verstanden werden kann. Auch bei der Bündelverteilungsoptik 30 ist das Haupt-Bündel 7, 7₁ₐ, 7₂ₐ, ... längs eines Zick-Zack-Weges geführt. Die Umlenkungen längs dieses Zick-Zack-Weges geschehen allerdings jeweils durch Blaze-Reflexionsgitter 9₁, 9₂, ..., so dass keine gesonderten Umlenkspiegel erforderlich sind. Der jeweils ausgekoppelte Strahl 7₁, 7₂, ... wird wiederum von Umlenkspiegeln 26, die Bestandteil der Auskoppeloptik sind, hin zu dem jeweiligen Objektfeld geführt.

## Patentansprüche

1. Bündelverteilungsoptik (8; 14; 23; 27; 29; 30) zum Aufteilen eines einfallenden Bündels von Beleuchtungslicht (7) in mindestens zwei ausfallende Nutz-Beleuchtungslicht-Bündel (7a, 7b; 7₅, 7₅ₐ; 7₁, 7₁ₐ), mit mindestens einem Blaze-Reflexionsgitter (9) mit reflektierenden Gitterstrukturen (17), **dadurch gekennzeichnet, dass** eine Gitterkonstante des Blaze-Reflexionsgitters (9) und ein Blaze-Winkel des Blaze-Reflexionsgitters (9) so auf eine Wellenlänge des Beleuchtungslichts (7) abgestimmt sind, dass innerhalb eines über eine Auswahl des Blaze-Winkels bevorzugten Reflexionsbereichs des Blaze-Reflexionsgitters (9) mehrere Beugungsordnungen des Blaze-Reflexionsgitters (9) mit vorgegebener Effizienz reflektiert werden.

2. Bündelverteilungsoptik nach Anspruch 1, **dadurch gekennzeichnet, dass** die Gitterstrukturen (17) des Blaze-Reflexionsgitters (9) zur Einstellung eines Blaze-Winkels aktorisch verlagerbar sind.

3. Bündelverteilungsoptik nach Anspruch 1 oder 2, **dadurch gekennzeichnet, dass** die Gitterstrukturen (17) als MEMS-Spiegel ausgebildet sind.

4. Bündelverteilungsoptik nach einem der Ansprüche 1 bis 3, **gekennzeichnet durch** eine Gitterperiode des Blaze-Reflexionsgitters (9), die 80 bis 150 Mal so groß ist wie eine Nutzwellenlänge des Beleuchtungslichts (7).

5. Bündelverteilungsoptik nach einem der Ansprüche 1 bis 4, mit einer Mehrzahl von sequenziell mit dem Beleuchtungslicht (7) beaufschlagten Blaze-Reflexionsgittern (9).

6. Bündelverteilungsoptik nach einem der Ansprüche 1 bis 5, **gekennzeichnet durch** eine Anordnung derart, dass jedes Beleuchtungslicht-Bündel (7₁ bis 7₈) innerhalb der Bündelverteilungsoptik (8) von den Gitterstrukturen (17) mehrerer Blaze-Reflexionsgitter (9) reflektiert wird.

7. Bündelverteilungsoptik nach einem der Ansprüche 1 bis 5, **dadurch gekennzeichnet, dass** von zwei von einem Blaze-Reflexionsgitter (9) erzeugten, ausfallenden Beleuchtungslicht-Bündeln (7₅, 7₅ₐ; 7₁, 7₁ₐ) maximal eines (7₅ₐ; 7₁ₐ) durch Reflexion an mindestens einem weiteren Blaze-Reflexionsgitter (9₂, ...) weiter aufgeteilt wird.

8. Beleuchtungsoptik (6) zur Ausleuchtung mindestens eines Objektfeldes (2) mit einer Bündelverteilungsoptik (8; 14; 23; 27; 29) nach einem der Ansprüche 1 bis 7.

9. Optisches System mit einer Beleuchtungsoptik (6) nach Anspruch 8 und mit mindestens einer Projektionsoptik (11) zur Abbildung des Objektfeldes (2) in ein Bildfeld (12).

10. Optisches System nach Anspruch 9, **dadurch gekennzeichnet, dass** mindestens eines der Blaze-Reflexionsgitter (9) der Bündelverteilungsoptik (27; 29) Teil einer Auskoppeloptik ist, die ein Beleuchtungslicht-Bündel (7₁, ...) hin zu einer von mehreren Projektionsoptiken (11) des optischen Systems lenkt.

11. Optisches System nach einem der Ansprüche 9 oder 10, **gekennzeichnet durch** eine Strahlführung derart, dass ein unausgekoppeltes Haupt-Bündel (7, 7₁ₐ, 7₂ₐ, ...) innerhalb der Bündelverteilungsoptik (23; 27) längs eines Zick-Zack-Weges verläuft.

12. Optisches System nach Anspruch 9 oder 10, **gekennzeichnet durch** eine Strahlführung derart, dass ein unausgekoppeltes Haupt-Bündel (7, 7₁ₐ, 7₂ₐ, ...) innerhalb der Bündelverteilungsoptik (29) längs eines polygonalen, jeweils in gleicher Richtung umgelenkten Weges verläuft.

13. Lithographische Projektionsbelichtungsanlage (1) mit einem optischen System nach einem der Ansprüche 9 bis 12 und einer primären Lichtquelle (5).

14. Verfahren zur mikrolithographischen Herstellung mikro- oder nanostrukturierter Bauelemente mit folgenden Schritten:
- Bereitstellen mehrerer Substrate, auf die zumindest teilweise eine Schicht aus einem lichtempfindlichen Material aufgebracht ist,
- Bereitstellen mehrerer Retikel, die abzubildende Strukturen aufweisen,
- Bereitstellen einer Projektionsbelichtungsanlage (1) nach Anspruch 13,
- Projizieren wenigstens eines Teils der Retikel auf einen Bereich der jeweiligen Schicht mit Hilfe der Projektionsbelichtungsanlage (1).

## Claims

1. Beam distribution optical unit (8; 14; 23; 27; 29; 30) for splitting an incident beam of illumination light (7) into at least two emergent used illumination-light beams (7a, 7b; 7₅, 7₅ₐ; 7₁, 7₁ₐ), having at least one blazed reflection grating (9) with reflective grating structures (17),
**characterized in that**
a grating constant of the blazed reflection grating (9) and a blaze angle of the blazed reflection grating (9) are tuned to a wavelength of the illumination light (7) such that a plurality of orders of diffraction of the blazed reflection grating (9) are reflected with a specified efficiency within a reflection region of the blazed reflection grating (9) that is preferred via a selection of the blaze angle.

2. Beam distribution optical unit according to Claim 1, **characterized in that** the grating structures (17) of the blazed reflection grating (9) are displaceable by means of actuation for adjusting a blaze angle.

3. Beam distribution optical unit according to Claim 1 or 2, **characterized in that** the grating structures (17) are in the form of MEMS mirrors.

4. Beam distribution optical unit according to one of Claims 1 to 3, **characterized by** a grating period of the blazed reflection grating (9) which is 80 to 150 times as large as a used wavelength of the illumination light (7) .

5. Beam distribution optical unit according to one of Claims 1 to 4, having a plurality of blazed reflection gratings (9) which are subjected sequentially to the illumination light (7).

6. Beam distribution optical unit according to one of Claims 1 to 5, **characterized by** an arrangement of the type such that each illumination-light beam (7₁ to 7₈) within the beam distribution optical unit (8) is reflected by the grating structures (17) of a plurality of blazed reflection gratings (9).

7. Beam distribution optical unit according to one of Claims 1 to 5, **characterized in that** of two emergent illumination-light beams (7₅, 7₅ₐ; 7₁, 7₁ₐ) produced by a blazed reflection grating (9) a maximum of one illumination-light beam (7₅ₐ; 7₁ₐ) is split further by reflection at at least one further blazed reflection grating (9₂, ...).

8. Illumination optical unit (6) for fully lighting at least one object field (2) with a beam distribution optical unit (8; 14; 23; 27; 29) according to one of Claims 1 to 7.

9. Optical system having an illumination optical unit (6) according to Claim 8 and having at least one projection optical unit (11) for imaging the object field (2) into an image field (12).

10. Optical system according to Claim 9, **characterized in that** at least one of the blazed reflection gratings (9) of the beam distribution optical unit (27; 29) is part of an output coupling optical unit which directs an illumination-light beam (7₁, ...) to one of a plurality of projection optical units (11) of the optical system.

11. Optical system according to Claim 9 or 10, **characterized by** beam guidance such that a non-decoupled main beam (7, 7₁ₐ, 7₂ₐ, ...) travels along a zigzag path within the beam distribution optical unit (23; 27).

12. Optical system according to Claim 9 or 10, **characterized by** beam guidance such that a non-decoupled main beam (7, 7₁ₐ, 7₂ₐ, ...) travels along a polygonal path, in each case deflected in the same direction, within the beam distribution optical unit (29).

13. Lithographic projection exposure apparatus (1) having an optical system according to one of Claims 9 to 12 and a primary light source (5).

14. Method for microlithographically producing microstructured or nanostructured components having the following steps:
- providing a plurality of substrates to which a layer composed of a light-sensitive material is at least partially applied,
- providing a plurality of reticles having structures to be imaged,
- providing a projection exposure apparatus (1) according to Claim 13,
- projecting at least some of the reticles onto a region of the respective layer with the aid of the projection exposure apparatus (1).

## Revendications

1. Optique de répartition de faisceaux (8 ; 14 ; 23 ; 27 ; 29 ; 30) permettant de répartir un faisceau incident de lumière d'éclairage (7) en au moins deux faisceaux de lumière d'éclairage utile émergents (7a, 7b ; 7₅, 7₅ₐ ; 7₁, 7₁ₐ) , comprenant au moins un réseau de réflexion blazé (9) ayant des structures de réseau réfléchissantes (17),
**caractérisée en ce qu'**une constante de réseau du réseau de réflexion blazé (9) et un angle de blaze du réseau de réflexion blazé (9) sont accordés à une longueur d'onde de la lumière d'éclairage (7) de telle sorte qu'à l'intérieur d'une zone de réflexion, préférée par une sélection de l'angle de blaze, du réseau de réflexion blazé (9), plusieurs ordres de diffraction du réseau de réflexion blazé (9) sont réfléchis avec une efficacité prédéfinie.

2. Optique de répartition de faisceaux selon la revendication 1, **caractérisée en ce que** les structures de réseau (17) du réseau de réflexion blazé (9) peuvent être décalées par actionneur pour régler un angle de blaze.

3. Optique de répartition de faisceaux selon la revendication 1 ou 2, **caractérisée en ce que** les structures de réseau (17) sont réalisées sous forme de miroirs MEMS.

4. Optique de répartition de faisceaux selon l'une quelconque des revendications 1 à 3, **caractérisée par** une période de réseau du réseau de réflexion blazé (9) qui est de 80 à 150 fois une longueur d'onde utile de la lumière d'éclairage (7).

5. Optique de répartition de faisceaux selon l'une quelconque des revendications 1 à 4, comprenant une pluralité de réseaux de réflexion blazés (9) sollicités séquentiellement par la lumière d'éclairage (7).

6. Optique de répartition de faisceaux selon l'une quelconque des revendications 1 à 5, **caractérisée par** un agencement tel que chaque faisceau de lumière d'éclairage (7₁ à 7₈) est réfléchi à l'intérieur de l'optique de répartition de faisceaux (8) par les structures de réseau (17) de plusieurs réseaux de réflexion blazés (9).

7. Optique de répartition de faisceaux selon l'une quelconque des revendications 1 à 5, **caractérisée en ce que** sur deux faisceaux de lumière d'éclairage émergents (7₅, 7₅ₐ ; 7₁, 7₁ₐ), produits par un réseau de réflexion blazé (9), au maximum un seul (7₅ₐ ; 7₁ₐ) est réparti davantage au niveau d'au moins un autre réseau de réflexion blazé (9₂, ...).

8. Optique d'éclairage (6) pour éclairer au moins un champ d'objet (2) par une optique de répartition de faisceaux (8 ; 14 ; 23 ; 27 ; 29) selon l'une quelconque des revendications 1 à 7.

9. Système optique comprenant une optique d'éclairage (6) selon la revendication 8 et comprenant au moins une optique de projection (11) pour reproduire le champ d'objet (2) dans un champ d'image (12).

10. Système optique selon la revendication 9, **caractérisé en ce qu'**au moins l'un des réseaux de réflexion blazés (9) de l'optique de répartition de faisceaux (27 ; 29) fait partie d'une optique de découplage qui dirige un faisceau de lumière d'éclairage (7₁, ...) vers l'une de plusieurs optiques de projection (11) du système optique.

11. Système optique selon l'une quelconque des revendications 9 et 10, **caractérisé par** un guidage de rayons tel qu'un faisceau principal non découplé (7, 71ₐ, 7₂ₐ, ...) s'étend à l'intérieur de l'optique de répartition de faisceaux (23 ; 27) le long d'un trajet en zigzag.

12. Système optique selon la revendication 9 ou 10, **caractérisé par** un guidage de rayon tel qu'un faisceau principal non découplé (7, 7₁ₐ, 7₂ₐ, ...) s'étend à l'intérieur de l'optique de répartition de faisceaux (29) le long d'un trajet polygonal, dévié respectivement dans la même direction.

13. Installation d'exposition par projection lithographique (1) comprenant un système optique selon l'une quelconque des revendications 9 à 12 et une source de lumière primaire (5).

14. Procédé de fabrication microlithographique de composants microstructurés ou nanostructurés, comprenant les étapes suivantes consistant à :
- fournir plusieurs substrats sur lesquels est appliquée au moins partiellement une couche d'un matériau photosensible,
- fournir plusieurs réticules qui présentent des structures à reproduire,
- fournir une installation d'exposition par projection (1) selon la revendication 13,
- projeter au moins une partie des réticules sur une zone de la couche respective à l'aide de l'installation d'exposition par projection (1).
